# EUROPEAN PATENT APPLICATION

(11) **EP 3 686 911 A1**
(43) Date of publication of application: **29.07.2020**
(21) Application number: 18857975.9
(22) Date of filing: 18.09.2018
(51) Int. Cl.: H01H 50/02

(54) **PRINTED CIRCUIT BOARD ASSEMBLY**

(30) Priority: 20.09.2017 KR 20170121296; 13.09.2018 KR 20180109783
(71) Applicant: Tyco Electronics AMP Korea Co., Ltd., Gyeongsan-si, Gyeongsangbuk-do 38459 (KR)
(72) Inventor: LEE, Jong Kyu, Gyeongsan-si Gyeongsangbuk-do 38459 (KR); JEON, Yong Man, Gyeongsan-si Gyeongsangbuk-do 38459 (KR)
(74) Representative: Johnstone, Douglas Ian
(86) International application number: PCT/KR2018/010957
(87) International publication number: WO 2019/059607

(57) **Abstract**

A printed circuit board assembly according to an embodiment may comprise: a printed circuit board which is partitioned into a base part, a first extension part, and a second extension part by a first curved part and a second curved part, the first and the second extension part being respectively arranged at opposite sides with reference to the base part; and a coupler mounted between the first extension part and the second extension part and preventing the first and the second extension part from approaching each other.

## Description

### Technical Field

The following description relates to a printed circuit board assembly.

### Background Art

A printed circuit board (PCB) refers to a circuit board on which various electrical components are mounted. The printed circuit board may be attached to an external module. Various electrical components mounted on the printed circuit board may be electrically connected to the external module.

### Disclosure of Invention

### Technical subject

An aspect provides a printed circuit board assembly with an enhanced structural stability.

### Technical solutions

According to an aspect, there is provided a printed circuit board assembly including a printed circuit board including a base part, a first extension part, and a second extension part, wherein the base part, the first extension part, and the second extension part are partitioned by a first curved part and a second curved part, and the first extension part and the second extension part are respectively located at opposite sides based on the base part, and a coupler mounted between the first extension part and the second extension part to prevent the first extension part and the second extension part from approaching each other.

The coupler may be configured to support the first extension part, the second extension part, and the base part.

The coupler may include a coupler body mounted between the first extension part and the second extension part to support inner side surfaces of the first extension part and the second extension part, a left coupler arm that extends from the coupler body and has at least a portion to be inserted into the first extension part, and a right coupler arm that extends from the coupler body and has at least a portion to be inserted into the second extension part.

At least one of the left coupler arm and the right coupler arm may include a coupler arm body that extends from the coupler body, a coupler arm support that extends from the coupler arm body to support an outer surface of the printed circuit board, and a coupler arm protrusion that protrudes from the coupler arm support in a direction vertical to the outer surface of the printed circuit board and is inserted into the printed circuit board.

The couple may further include a left coupler protrusion that protrudes from the coupler body to be inserted into the first extension part, and a right coupler protrusion that protrudes from the coupler body to be inserted into the second extension part.

The coupler may be configured to protrude above the first extension part and the second extension part based on a state in which the coupler supports the base part.

The printed circuit board assembly may further include a housing configured to accommodate the printed circuit board. The housing may be configured to support the coupler. The coupler may be configured to support the base part. The first extension part and the second extension part may be spaced apart from the housing.

The printed circuit board assembly may further include a housing configured to accommodate the printed circuit board. The first curved part and the second curved part may be spaced apart from the coupler and the housing.

The coupler may include a coupler body mounted between the first extension part and the second extension part to support inner side surfaces of the first extension part and the second extension part, and a support member that protrudes from an inner side surface of the coupler body to support the base part.

The coupler may include a coupler body mounted between the first extension part and the second extension part to support inner side surfaces of the first extension part and the second extension part, a left insert member that protrudes from the coupler body to be inserted into the first extension part, and a right insert member that protrudes from the coupler body to be inserted into the second extension part.

At least one of the left insert member and the right insert member may be provided as a plurality of insert members spaced apart in a height direction of the coupler body.

### Effects

According to an example embodiment, a coupler of a printed circuit board assembly may prevent a printed circuit board from being bent inwardly or outwardly, thereby enhancing a durability of the printed circuit board.

Further, according to an example embodiment, a coupler of a printed circuit board assembly may prevent deformation of a printed circuit board or collision of the printed circuit board with a housing while the printed circuit board is mounted to an external module.

Further, according to an example embodiment, a coupler of a printed circuit board assembly may assist two facing parts of a printed circuit board to be maintained in parallel.

Further, according to an example embodiment, a printed circuit board may be compactly accommodated in a curved state in a housing.

### Brief Description of Drawings

The present disclosure will become more fully understood from the detailed description given herein and the accompanying drawings, which are given by illustration only, and thus are not limitative of the present disclosure.
FIG. 1 is a perspective view illustrating a printed circuit board assembly according to an example embodiment.
FIG. 2 is an exploded perspective view illustrating a printed circuit board assembly according to an example embodiment.
FIG. 3 is a perspective view illustrating a coupler attached to a printed circuit board according to an example embodiment.
FIG. 4 is a perspective view illustrating a printed circuit board according to an example embodiment.
FIG. 5 is a plan view illustrating a coupler according to an example embodiment.
FIG. 6 is a cross-sectional view illustrating a printed circuit board assembly according to an example embodiment.

### Best Mode for Carrying Out the Invention

This application claims priority based on Korean Patent Application No. 2017-0121296 filed on September 20, 2017, in the Korean Intellectual Property Office, the entire disclosure of which is incorporated herein by reference for all purposes.

Hereinafter, some example embodiments will be described in detail with reference to the accompanying drawings. Regarding the reference numerals assigned to the elements in the drawings, it should be noted that the same elements will be designated by the same reference numerals, wherever possible, even though they are shown in different drawings. Also, in the description of embodiments, detailed description of well-known related structures or functions will be omitted when it is deemed that such description will cause ambiguous interpretation of the present disclosure.

In addition, terms such as first, second, A, B, (a), (b), and the like may be used herein to describe components. Each of these terminologies is not used to define an essence, order or sequence of a corresponding component but used merely to distinguish the corresponding component from other component(s). It should be noted that if it is described in the specification that one component is "connected", "coupled", or "joined" to another component, a third component may be "connected", "coupled", and "joined" between the first and second components, although the first component may be directly connected, coupled or joined to the second component.

A component having a common function with a component included in one example embodiment is described using a like name in another example embodiment. Unless otherwise described, a description made in one example embodiment may be applicable to another example embodiment and a detailed description within a duplicate range is omitted.

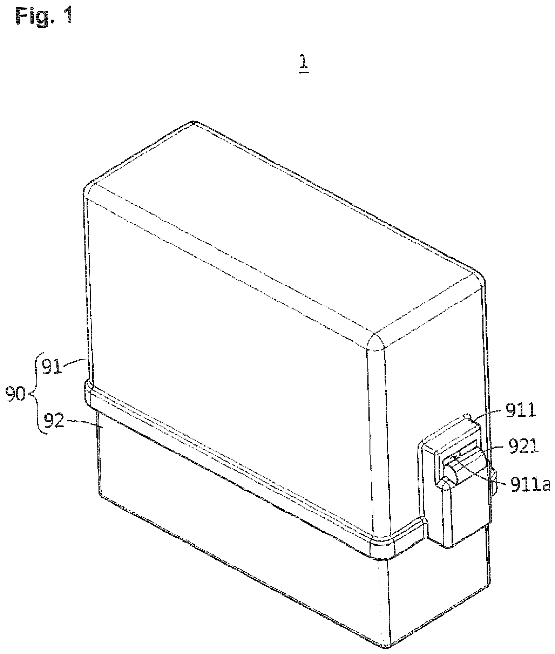

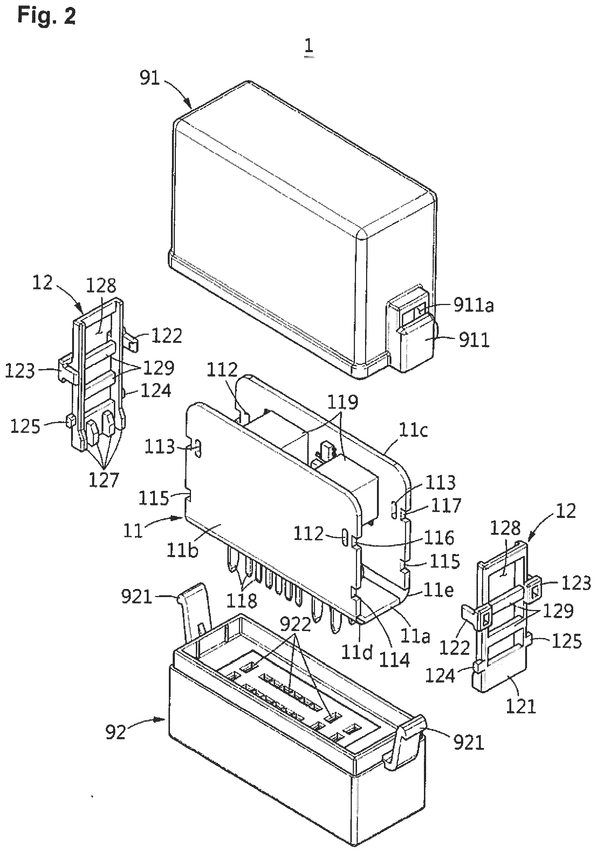

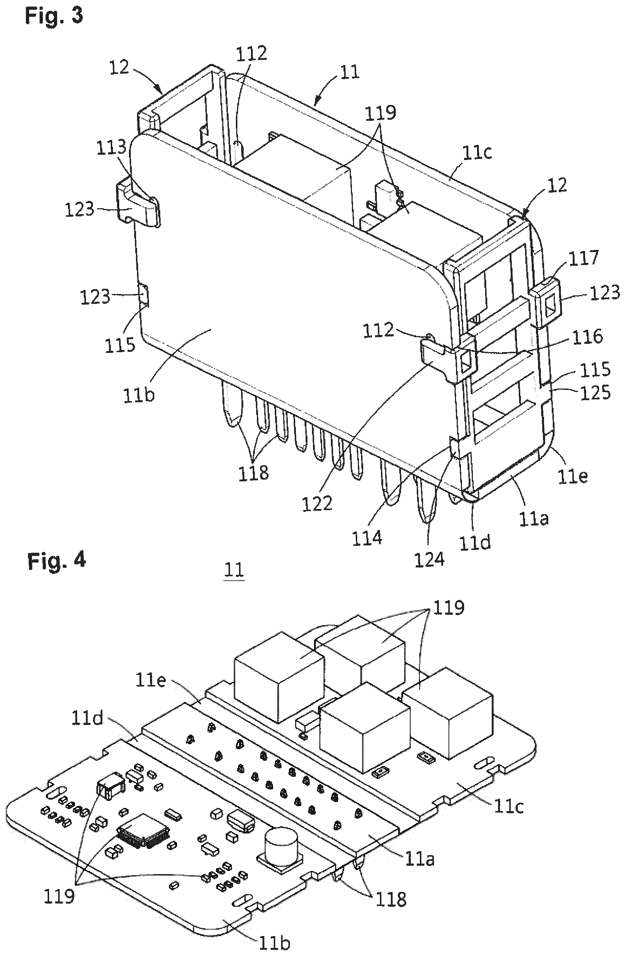

FIG. 1 is a perspective view illustrating a printed circuit board assembly according to an example embodiment, FIG. 2 is an exploded perspective view illustrating a printed circuit board assembly according to an example embodiment, FIG. 3 is a perspective view illustrating a coupler attached to a printed circuit board according to an example embodiment, and FIG. 4 is a perspective view illustrating a printed circuit board according to an example embodiment.

Referring to FIGS. 1 through 4, a printed circuit board assembly 1 may include a printed circuit board 11, a coupler 12, and a housing 90.

The printed circuit board 11 may be deformed. For example, the printed circuit board 11 may be changed from a flat plate shape (see FIG. 4) to a U-shape (see FIG. 2), and vice versa. The printed circuit board 11 may include a base part 11a, a first extension part 11b, a second extension part 11c, a first curved part 11d, and a second curved part 11e. Based on the base part 11a, the first extension part 11b and the second extension part 11c may be located at opposite sides. Each of the first extension part 11b and the second extension part 11c may rotate relative to the base part 11a.

The printed circuit board 11 may include connecting pins 118 and electrical components 119. The electrical components 119 may be electrically connected. The connecting pins 118 may electrically connect the electrical components 119 to an external module. For example, the connecting pins 118 may be inserted into the external module. For example, the connecting pins 118 may be provided in the base part 11a and the electrical components 119 may be provided in the first extension part 11b and the second extension part 11c. The printed circuit board 11 may be deformed to have the U-shape such that the electrical components 119 are located inside the first extension part 11b and the second extension part 11c. Due to this shape, the printed circuit board 11 may be compactly accommodated in the housing 90.

The printed circuit board 11 may include a first mounting hole 112, a second mounting hole 113, a first mounting recess 114, a second mounting recess 115, a first mounting guide recess 116, and a second mounting guide recess 117. The first mounting hole 112 may receive at least a portion of a left coupler arm 122. The second mounting hole 113 may receive at least a portion of a right coupler arm 123. The first mounting recess 114 may receive at least a portion of a left coupler protrusion 124. The second mounting recess 115 may receive at least a portion of a right coupler protrusion 125. The first mounting guide recess 116 and the second mounting guide recess 117 may be respectively in front of the first mounting hole 112 and the second mounting hole 113 to guide mounting of the left coupler arm 122 and the right coupler arm 123. By preparing a minimum number of mounting holes (for example, two mounting holes for each of the couplers 12), the printed circuit board 11 may secure a large area for accommodating the electrical components 119.

The coupler 12 may prevent the first extension part 11b and the second extension part 11c of the printed circuit board 11 from approaching each other. The coupler 12 may be disposed between an inner side surface of the first extension part 11b and an inner side surface of the second extension part 11c. Here, the inner side surface of the first extension part 11b may refer to a surface facing the second extension part 11c. The outer side surface of the first extension part 11b may face an inner wall of the housing 90. Likewise, the inner side surface of the second extension part 11c may refer to a surface facing the first extension part 11b. An outer side surface of the second extension part 11c may face another inner wall of the housing 90. The coupler 12 may maintain a minimum distance between the first extension part 11b and the second extension part 11c. For example, two couplers 12 may be provided. The two couplers 12 may be mounted to the printed circuit board 11 to face each other in a direction in which a distance therebetween decreases.

The coupler 12 may be in surface contact with the first extension part 11b and the second extension part 11c. The coupler 12 may include a coupler body 121, the left coupler arm 122, the right coupler arm 123, the left coupler protrusion 124, the right coupler protrusion 125, a support member 127, a heat dissipation hole 128, and a reinforcing rib 129.

The coupler body 121 may be mounted between the first extension part 11b and the second extension part 11c. The coupler body 121 may support the inner side surface of the first extension part 11b and the inner side surface of the second extension part 11c. While the printed circuit board 11 is mounted to the external module, the coupler body 121 may prevent the printed circuit board 11 from being directly shocked or prevent the base part 11a from being bent up. A left side surface of the coupler body 121 may be in contact with the inner side surface of the first extension part 11b. A right side surface of the coupler body 121 may be in contact with the inner side surface of the second extension part 11c. A lower side surface of the coupler body 121 may be in contact with a top surface of the base part 11a. Here, the top surface of the base part 11a may be a surface facing an extension direction of the first extension part 11b and the second extension part 11c. A width of the coupler body 121 may be approximately equal to a distance between the first extension part 11b and the second extension part 11c when the first extension part 11b is parallel with the second extension part 11c.

The left coupler arm 122 may extend from the coupler body 121. At least a portion of the left coupler arm 122 may be inserted into the first extension part 11b or the second extension part 11c. For example, when the two couplers 12 are provided as shown in the drawing, the left coupler arm 122 of one of the two couplers 12 may be inserted into the first extension part 11b and the left coupler arm 122 of the other one may be inserted into the second extension part 11c. Hereinafter, for ease and brevity, the following description will be made based on the coupler 12 of which the left coupler arm 122 is inserted into the first extension part 11b. However, this is merely an example and embodiments are not limited thereto. The left coupler arm 122 may support the outer side surface of the first extension part 11b. For example, the left coupler arm 122 may be shaped to be in surface contact with the first extension part 11b. The left coupler arm 122 may prevent the first extension part 11b from rotating to be away from the second extension part 11c. In other words, the left coupler arm 122 may limit a maximum angle of the first extension part 11b relative to the base part 11a. At least a portion of the left coupler arm 122 may be inserted into the first mounting hole 112. Before the left coupler arm 122 is inserted into the first mounting hole 112, the first mounting guide recess 116 may temporarily accept the left coupler arm 122 to guide a mounting direction of the left coupler arm 122.

The right coupler arm 123 may extend from the coupler body 121. At least a portion of the right coupler arm 123 may be inserted into the second extension part 11c. The right coupler arm 123 may support the outer side surface of the second extension part 11c. For example, the right coupler arm 123 may be shaped to be in surface contact with the second extension part 11c. The right coupler arm 123 may prevent the second extension part 11c from rotating to be away from the first extension part 11b. In other words, the right coupler arm 123 may limit a maximum angle of the second extension part 11c relative to the base part 11a. At least a portion of the right coupler arm 123 may be inserted into the second mounting hole 113. Before the right coupler arm 123 is inserted into the second mounting hole 113, the second mounting guide recess 117 may temporarily accept the right coupler arm 123 to guide a mounting direction of the right coupler arm 123. The right coupler arm 123 may be, for example, symmetric to the left coupler arm 122 based on a center axis of the coupler body 121.

When at least a portion of each of the left coupler arm 122 and the right coupler arm 123 is inserted into the printed circuit board 11, the first extension part 11b and the second extension part 11c of the printed circuit board 11 may be restricted not to slide to each other while being maintained in a parallel state. For example, the left coupler arm 122 inserted in the first extension part 11b may restrict the first extension part 11b not to slide upward or downward relative to the second extension part 11c.

The coupler body 121 may prevent the first extension part 11b and the second extension part 11c from approaching each other. The left coupler arm 122 and the right coupler arm 123 may prevent an increase of the distance between the first extension part 11b and the second extension part 11c. Through this, the printed circuit board 11 may be maintained in an original shape.

The left coupler protrusion 124 may protrude from the coupler body 121 and be inserted into the first mounting recess 114. The first mounting recess 114 may be recessed from a side surface of the printed circuit board 11 in the mounting direction of the coupler 12. A width of the left coupler protrusion 124 may be less than or equal to a width of a protrusion of the first mounting recess 114. For example, the left coupler protrusion 124 may be forcedly fit into the first mounting recess 114. The left coupler protrusion 124 may have a shape corresponding to that of the first mounting recess 114.

The right coupler protrusion 125 may protrude from the coupler body 121. The right coupler protrusion 125 may protrude in a direction opposite to a protruding direction of the left coupler protrusion 124. The right coupler protrusion 125 may be inserted into the second mounting recess 115. The second mounting recess 115 may be recessed from a side surface of the printed circuit board 11 in the mounting direction of the coupler 12. A width of the right coupler protrusion 125 may be less than or equal to a width of a protrusion of the second mounting recess 115. For example, the right coupler protrusion 125 may be forcedly fit into the second mounting recess 115. The right coupler protrusion 125 may have a shape corresponding to that of the second mounting recess 115. The right coupler protrusion 125 may be, for example, symmetric to the left coupler protrusion 124 based on the center axis of the coupler body 121.

The left coupler protrusion 124 and the right coupler protrusion 125 may be below the left coupler arm 122 and the right coupler arm 123, respectively. For example, the left coupler arm 122 and the right coupler arm 123 may extend from an upper portion of the coupler body 121. Also, the left coupler protrusion 124 and the right coupler protrusion 125 may protrude from a lower portion of the coupler body 121. In this case, the left coupler protrusion 124 and the right coupler protrusion 125 may be inserted into a portion having a relatively less degree of positional change while the first and second extension parts 11b and 11c are rotating relative to the base part 11a. Also, the left coupler arm 122 and the right coupler arm 123 may be inserted into a portion having a relatively large degree of positional change. Therefore, a user may mount the coupler 12 to the printed circuit board 11 using a relatively less force.

When at least a portion of each of the left coupler protrusion 124 and the right coupler protrusion 125 is inserted into the printed circuit board 11, the first extension part 11b and the second extension part 11c of the printed circuit board 11 may be restricted not to slide to each other while being maintained in a parallel state.

The coupler 12 may include a left insert member that protrudes from the coupler body 121 to be inserted into the first extension part 11b. For example, the left insert member may include the left coupler arm 122 and/or the left coupler protrusion 124, but not be limited thereto. The coupler 12 may also include a right insert member that protrudes from the coupler body 121 to be inserted into the second extension part 11c. For example, the right insert member may include the right coupler arm 123 and the right coupler protrusion 125, but not be limited thereto. The left insert member and/or the right insert member may be provided as a plurality of insert members spaced apart from one another in a height direction of the coupler body 121.

The support member 127 may protrude from an inner side surface of the coupler body 121 and support the base part 11a. Here, the inner side surface of the coupler body 121 may be a surface facing the electrical components 119 in a state in which the coupler 12 is attached to the printed circuit board 11. The support member 127 may be provided in a lower portion of the coupler body 121. The support member 127 may increase a contacting area between the coupler 12 and the base part 11a. The support member 127 may be provided as a plurality of support members. The plurality of support members 127 may be spaced apart in a width direction of the coupler body 121. The support member 127 may include a shape in which a thickness increases toward a bottom. For example, a top of the support member 127 may have an oblique shape. The support member 127 may reinforce a rigidity of the first curved part 11d and the second curved part 11e, which are relatively vulnerable to bending.

The heat dissipation hole 128 may serve to effectively transfer heat generated in the electrical components 119 of the printed circuit board 11 to outside. The heat dissipation hole 128 may penetrate the coupler body 121 in a direction in which the coupler 12 is mounted to the printed circuit board 11. Though the heat dissipation hole 128, the electrical components 119 may be exposed outside.

The reinforcing rib 129 may connect two edge portions of the coupler body 121 to enhance the structural stability of the coupler body 121. The reinforcing rib 129 may be provided in plural.

The housing 90 may accept the printed circuit board 11 and the coupler 12. The housing 90 may include an upper housing 91 and a lower housing 92 that are separated or connected to each other.

The upper housing 91 may have a space to accommodate the printed circuit board 11 and the coupler 12. The upper housing 91 may include a connector 911 to be connected with the lower housing 92. The connector 911 may include a receiving hole 911a.

The lower housing 92 may be connected to the upper housing 91. When the lower housing 92 is connected to the upper housing 91, the lower housing 92 may support the printed circuit board 11 and the upper housing 91 may support the coupler 12. The lower housing 92 may include an insertion 921 that is inserted into the connector 911 and pin receivers 922 that receive the connecting pins 118 of the printed circuit board 11. The insertion 921 may slide along the connector 911 while being pressed inwardly. When the lower housing 92 is fully connected with the upper housing 91, the insertion 921 may be mounted in the receiving hole 911a.

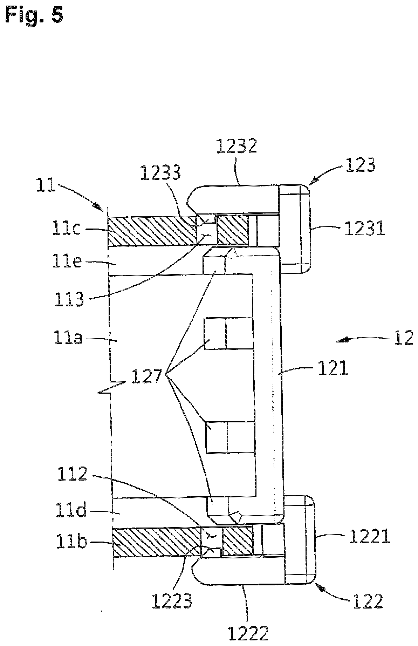

FIG. 5 is a plan view illustrating a coupler according to an example embodiment.

Referring to FIG. 5, at least one of the left coupler arm 122 and the right coupler arm 123 may include a coupler arm body that extends from the coupler body 121, a coupler arm support that extends from the coupler arm body to support an outer surface of the printed circuit board 11, and a coupler arm protrusion that protrudes from the coupler arm support in a direction vertical to the outer surface of the printed circuit board and is inserted into the printed circuit board. The following description will be made based on the left coupler arm 122 and the right coupler arm 123, each including the coupler arm body, the coupler arm support, and the coupler arm protrusion. However, embodiments are not limited thereto.

The left coupler arm 122 may include a left coupler arm body 1221, a left coupler arm support 1222, and a left coupler arm protrusion 1223.

The left coupler arm body 1221 may extend from the coupler body 121. The left coupler arm body 1221 may be in contact with one surface of the printed circuit board 11.

The left coupler arm support 1222 may extend in a direction vertical to the left coupler arm body 1221. The left coupler arm support 1222 may support the outer surface of the printed circuit board 11. Here, the outer surface of the printed circuit board 11 may be a surface facing a surface that faces the coupler body 121 in a state in which the coupler 12 is mounted on the printed circuit board 11. The left coupler arm support 1222 may be in surface contact with the printed circuit board 11, for example, an outer surface of the first extension part 11b.

The left coupler arm protrusion 1223 may protrude from the left coupler arm support 1222 in the direction vertical to the outer surface of the printed circuit board 11. The left coupler arm protrusion 1223 may be inserted into the printed circuit board 11, for example, the first extension part 11b.

The right coupler arm 123 may include a right coupler arm body 1231, a right coupler arm support 1232, and a right coupler arm protrusion 1233.

The right coupler arm body 1231 may extend from the coupler body 121. The right coupler arm body 1231 may extend in a direction opposite to an extension direction of the left coupler arm body 1221. The right coupler arm body 1231 may be in contact with one surface of the printed circuit board 11.

The right coupler arm support 1232 may extend in a direction vertical to the right coupler arm body 1231. The right coupler arm support 1232 may support the outer surface of the printed circuit board 11. The right coupler arm support 1232 may be in surface contact with the printed circuit board 11, for example, an outer surface of the second extension part 11c.

The right coupler arm protrusion 1233 may protrude from the right coupler arm support 1232 in the direction vertical to the outer surface of the printed circuit board 11. The right coupler arm protrusion 1233 may be inserted into the printed circuit board 11, for example, the second extension part 11c.

The plurality of support members 127 may be in contact with the base part 11a and increase a contacting area between the coupler 12 and the printed circuit board 11.

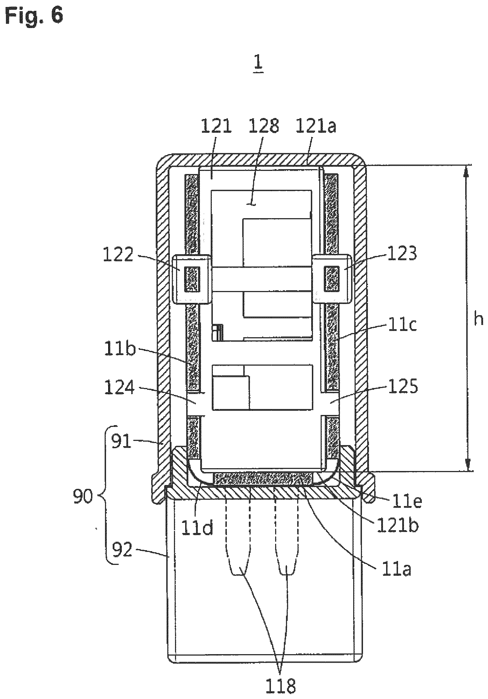

FIG. 6 is a cross-sectional view illustrating a printed circuit board assembly according to an example embodiment.

Referring to FIG. 6, the printed circuit board 11 on which the coupler 12 is mounted may be contained in the housing 90. The printed circuit board 11 may be prevented from being narrowed inward by the coupler body 121. The printed circuit board 11 may be prevented from being widened by the left coupler arm 122 and the right coupler arm 123. Also, relative vertical movements of the first extension part 11b and the second extension part 11c may be restricted by the left coupler arm 122, the right coupler arm 123, the left coupler protrusion 124, and the right coupler protrusion 125. Through this, the printed circuit board 11 may be accommodated in the housing 90 while being maintained in a compact structure without deformation.

Based on a state in which the printed circuit board 11 is accommodated in the housing 90, a bottom surface of the base part 11a of the printed circuit board 11 may be supported by a top surface of the lower housing 92 and a top surface of the base part 11a may be supported by a bottom surface 121b of the coupler body 121. A top surface 121a of the coupler body 121 may be supported by the upper housing 91, so that the deformation of the printed circuit board 11 and/or wobbling of the connecting pins 118 may be prevented.

Based on a state in which the coupler 12 supports the base part 11a, the coupler 12 may protrude above the first extension part 11b and the second extension part 11c. For example, a height h of the coupler body 121 may be greater than a vertical distance from the top surface of the base part 11a to the top of the first extension part 11b and a vertical distance from the top surface of the base part 11a to the top of the second extension part 11c. When the top surface 121a of the coupler body 121 contacts an inner wall of the upper housing 91, upper ends of the first extension part 11b and the second extension part 11c may be spaced apart from the inner wall of the upper housing 91. The coupler 12 may support the base part 11a and prevent the first extension part 11b and the second extension part 11c from directly contacting the upper housing 91, thereby enhancing a durability of the printed circuit board 11.

The first curved part 11d and the second curved part 11e may be spaced apart from the coupler 12 and the housing 90. For example, the housing 90 may include a "U" shape and support the base part 11a and the first and second extension parts 11b and 11c. Since the first curved part 11d and the second curved part 11e do not contact the housing 90, an impact applied to the first curved part 11d and the second curved part 11e may be reduced while the printed circuit board 11 is mounted to the external module.

A number of example embodiments have been described above. Nevertheless, it should be understood that various modifications may be made to these example embodiments. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A printed circuit board assembly comprising:
a printed circuit board comprising a base part, a first extension part, and a second extension part, wherein the base part, the first extension part, and the second extension part are partitioned by a first curved part and a second curved part, and the first extension part and the second extension part are respectively located at opposite sides based on the base part; and
a coupler mounted between the first extension part and the second extension part to prevent the first extension part and the second extension part from approaching each other.

2. The printed circuit board assembly of claim 1, wherein the coupler is configured to support the first extension part, the second extension part, and the base part.

3. The printed circuit board assembly of claim 1, wherein the coupler comprises:
a coupler body mounted between the first extension part and the second extension part to support inner side surfaces of the first extension part and the second extension part;
a left coupler arm that extends from the coupler body and has at least a portion to be inserted into the first extension part; and
a right coupler arm that extends from the coupler body and has at least a portion to be inserted into the second extension part.

4. The printed circuit board assembly of claim 3, wherein at least one of the left coupler arm and the right coupler arm comprises:
a coupler arm body that extends from the coupler body;
a coupler arm support that extends from the coupler arm body to support an outer surface of the printed circuit board; and
a coupler arm protrusion that protrudes from the coupler arm support in a direction vertical to the outer surface of the printed circuit board and is inserted into the printed circuit board.

5. The printed circuit board assembly of claim 1 or 3, wherein the coupler further comprises:
a left coupler protrusion that protrudes from the coupler body to be inserted into the first extension part; and
a right coupler protrusion that protrudes from the coupler body to be inserted into the second extension part.

6. The printed circuit board assembly of claim 1, wherein the coupler is configured to protrude above the first extension part and the second extension part based on a state in which the coupler supports the base part.

7. The printed circuit board assembly of claim 1, further comprising:
a housing configured to accommodate the printed circuit board,
wherein the housing is configured to support the coupler,
the coupler is configured to support the base part, and
the first extension part and the second extension part are spaced apart from the housing.

8. The printed circuit board assembly of claim 1, further comprising:
a housing configured to accommodate the printed circuit board,
wherein the first curved part and the second curved part are spaced apart from the coupler and the housing.

9. The printed circuit board assembly of claim 1, wherein the coupler comprises:
a coupler body mounted between the first extension part and the second extension part to support inner side surfaces of the first extension part and the second extension part; and
a support member that protrudes from an inner side surface of the coupler body to support the base part.

10. The printed circuit board assembly of claim 1, wherein the coupler comprises:
a coupler body mounted between the first extension part and the second extension part to support inner side surfaces of the first extension part and the second extension part;
a left insert member that protrudes from the coupler body to be inserted into the first extension part; and
a right insert member that protrudes from the coupler body to be inserted into the second extension part.

11. The printed circuit board assembly of claim 10, wherein at least one of the left insert member and the right insert member is provided as a plurality of insert members spaced apart in a height direction of the coupler body.
